(19) Europäisches Patentamt
European Patent Office
Office européen des brevets

(11) Veröffentlichungsnummer: **0 262 453**
**A2**

(12) **EUROPÄISCHE PATENTANMELDUNG**

(21) Anmeldenummer: **87112948.2**

(22) Anmeldetag: **04.09.87**

(51) Int. Cl.4: **H05K 7/14** , H05K 7/18

(30) Priorität: **30.09.86 DE 3633205**

(43) Veröffentlichungstag der Anmeldung:
**06.04.88 Patentblatt 88/14**

(84) Benannte Vertragsstaaten:
**AT BE CH DE ES FR GB GR IT LI LU NL SE**

(71) Anmelder: **Rittal-Werk Rudolf Loh GmbH & Co. KG**
**Auf dem Stützelberg**
**D-6348 Herborn(DE)**

(72) Erfinder: **Berg, Franco**
**Am Walde 2**
**D-3304 Isernhagen(DE)**
Erfinder: **Bovermann, Claus-Dieter**
**Am Oberg 7**
**D-3565 Breidenbach-Niederdieten(DE)**

(74) Vertreter: **Vogel, Georg**
**Hermann-Essig-Strasse 35**
**D-7141 Schwieberdingen(DE)**

(54) **Tragevorrichtung für quaderförmige Gehäuse elektrischer Geräte, insbesondere für 19"-Tischgehäuse.**

(57) Die Erfindung betrifft eine Tragevorrichtung für quaderförmige Gehäuse elektrischer Geräte, insbesondere für 19"-Tischgehäuse, bei der an zwei einander gegenüberliegenden vertikalen Seitenwänden des Gehäuses jeweils eine Vertiefung eingebracht ist, in der ein Tragebügel schwenkbar gelagert und aus einer mit der Seitenwand bündigen Ausgangsstellung in eine aus der Vertiefung ragenden Tragestellung ausschwenkbar ist. Eine variable, nachträglich leicht änderbare Anbringung der Tragebügel am Gehäuse wird nach einer Erfindung dadurch erreicht, daß der Tragebügel aus einem Griffteil mit einer auf die horizontale und vertikale Abmessung der Vertiefung angepaßter Länge und zwei Schenkelteilen U-förmig zusammengesetzt ist, daß die freien Enden der Schenkelteile des Tragebügels in zwei Befestigungswinkeln drehbar gelagert sind, wobei die Drehachsen parallel zu dem Griffteil und einem Schenkel der Befestigungswinkel verlaufen und daß die Außenflächen der Befestigungswinkel eines Tragebügels je nach Länge des Griffteiles im Bereich der beiden, einer vertikalen oder einer horizontalen Seitenwand, zugeordneten Ecken der Vertiefung anliegend mit den Seitenwänden der Vertiefung verbunden sind.

FIG.1

## Tragevorrichtung für quaderförmige Gehäuse elektrischer Geräte, insbesondere für 19"-Tischgehäuse

Die Erfindung betrifft eine Tragevorrichtung für quaderförmige Gehäuse elektrischer Geräte, insbesondere für 19"-Tischgehäuse, bei der an zwei einander gegenüberliegenden vertikalen Seitenwänden des Gehäuses jeweils eine Vertiefung eingebracht ist, in der ein Tragebügel schwenkbar gelagert und aus einer mit der Seitenwand bündigen Ausgangsstellung in eine aus der Vertiefung ragenden Tragestellung ausschwenkbar ist.

Bei bekannten Tragevorrichtungen dieser Art sind die Vertiefungen in den Seitenwänden des Gehäuses als muldenartige Einbuchtungen ausgebildet. In dem nach innen eingezogenen Teil der Seitenwand sind U-förmige Tragebügel mit ihren abgewinkelten Enden in ausgestanzten und ausgebogenen Lagerschalen drehbar gelagert. Dabei ist das Griffteil des Tragebügels stets horizontal ausgerichtet. Eine nachträgliche Änderung der Ausrichtung des Tragebügels scheidet bei dieser bekannten Tragevorrichtung aus.

Dasselbe gilt auch für eine Tragevorrichtung, wie sie die DE-OS 33 33 826 zeigt. Die Schenkelteile des Tragebügels sind halbkreisförmig ausgelegt und im Gehäuse so gelagert, daß das Griffteil des Tragebügels aus einer mit der Seitenwand bündigen Ausgangsstellung in eine aus der Vertiefung ragenden Arbeitsstellung ausgeschwenkt werden kann. Bei dieser bekannten Tragevorrichtung ist die Vertiefung auf die Abmessung des Griffteiles abgestimmt und damit liegt auch die Ausrichtung der Schwenkachse fest und kann nachträglich nicht mehr verändert werden.

Es ist Aufgabe der Erfindung, eine Tragevorrichtung der eingangs erwähnten Art zu schaffen, bei der in einfacher Art die Ausrichtung der Tragebügel in der Vertiefung auch nachträglich noch geändert werden kann.

Diese Aufgabe wird nach der Erfindung dadurch gelöst, daß der Tragebügel aus einem Griffteil mit einer auf die horizontale und vertikale Abmessung der Vertiefung angepaßter Länge und zwei Schenkelteilen U-förmig zusammengesetzt ist, daß die freien Enden der Schenkelteile des Tragebügels in zwei Befestigungswinkeln drehbar gelagert sind, wobei die Drehachsen parallel zu dem Griffteil und einem Schenkel der Befestigungswinkel verlaufen und daß die Außenflächen der Befestigungswinkel eines Tragebügels je nach Länge des Griffteiles im Bereich der beiden, einer vertikalen oder einer horizontalen Seitenwand, zugeordneten Ecken der Vertiefung anliegend mit den Seitenwänden der Vertiefung verbunden sind.

Durch die Zusammensetzung des Tragebügels aus einem Griffteil und zwei Schenkelteilen ist es einfach möglich, den Tragebügel an die Abmessung der Vertiefung anzupassen und so die einheitliche Befestigung der Befestigungswinkel an den Seitenwänden der Vertiefungen beibehalten zu können, auch wenn die Vertiefung horizontal eine andere Abmessung wie vertikal aufweist. Weist das Gehäuse eine quadratische Vertiefung auf, dann kann der Tragebügel einheitlich gestaltet und in vier verschiedenen Stellungen in der Vertiefung montiert werden.

Die Verbindung der Befestigungswinkel an den Seitenwänden der Vertiefung wird dadurch vereinfacht und verbessert, daß die Seitenwände der Vertiefung eine umlaufende Nut oder eine umlaufende Feder aufweisen und daß die den Seitenwänden zugekehrten Außenflächen der Befestigungswinkel mit entsprechenden, längs der Schenkel derselben verlaufenden Federn oder Nuten versehen sind, die mit den Nuten oder Federn der Vertiefungen in Eingriff bringbar sind.

Die Drehlagerung der Tragebügel in den Befestigungswinkeln ist nach einer Ausgestaltung so gelöst, daß die Enden der Schenkelteile des Tragebügels in einer Aussparung auf der Innenseite des einen Schenkels des Befestigungswinkels drehbar gelagert ist, wobei die Aussparung bis an die Innenseite des anderen Schenkels des Befestigungswinkels heranreicht.

Das Einsetzen der Befestigungswinkel in die Ecken der Vertiefung wird dadurch verbessert, daß die Ecken der Vertiefungen und der Befestigungswinkel abgeschrägt sind und daß sich die Nuten und Federn über diese abgeschrägten Bereiche der Vertiefungen und Befestigungswinkel fortsetzen, wobei auch in diesen Bereichen die Nut-Feder-Verbindung aufrechterhalten wird.

Mit der Ausrichtung der Befestigungswinkel über die Nut-Feder-Verbindung läßt sich das Anbringen an den Seitenwänden der Vertiefung dadurch vereinfachen, daß mindestens ein Schenkel des Befestigungswinkels mit einem Befestigungsloch für ein Verbindungsmittel versehen ist und daß in den Eckbereichen der Vertiefungen auf das Befestigungsloch abgestimmt jeweils mindestens eine Befestigungsaufnahme für das Verbindungsmittel eingebracht ist. Dabei ist nach einer bevorzugten Ausführung vorgesehen, daß das Befestigungsloch für eine mit Senkkopf vorgesehene Senkkopfschraube als Verbindungsmittel ausgebildet ist und daß die Befestigungsaufnahme als Gewindesackloch für die Senkkopfschraube ausgelegt ist.

Für die Bildung der Vertiefungen an den Seitenwänden des Gehäuses sieht eine weitere Ausgestaltung vor, daß die Seitenwände der Vertiefungen mittels vertikaler und horizontaler Leisten gebildet sind, die über die Außenseite der Gehäusewand vorstehen.

In der Ausgangsstellung schließt sich der Tragebügel bündig an die Außenflächen der Seitenwände an, wenn vorgesehen ist, daß die Schenkelteile im Verbindungsbereich mit dem Griffteil so verbreitert sind, daß sie mit den Außenflächen der zugekehrten Schenkel bündig abschließen, wobei die Schenkelteile mit ihrer Außenkontur den zugekehrten Schenkel des in der Ausgangsstellung befindlichen Befestigungswinkels aufnehmen.

Ist nach einer Ausgestaltung vorgesehen, daß das Griffteil als Abschnitt eines Hohlprofils mit einer durchgehenden hülsenförmigen Befestigungsaufnahme ausgebildet ist, dann läßt sich das Griffteil einfach mit den Schenkelteilen verschrauben. Die Schenkelteile brauchen nur mit auf diese hülsenförmige Befestigungsaufnahme ausgerichteten Bohrungen versehen zu sein.

Das Fassen des Tragebügels in der Ausgangsstellung wird dadurch erleichtert, daß die den Drehhachsen abgekehrte Außenseite des Griffteils und die anschließenden Stirnseiten der Schenkelteile so abgeschrägt sind, daß das Griffteil und die Schenkelteile in der Ausgangsstellung des Tragebügels einen Hinterschnitt bilden. Die Griffigkeit wird dabei dadurch noch erhöht, daß die Außenseite des Griffteils treppenförmig gestaltet ist.

Eine definierte Arbeitsstellung der Tragebügel erhält man einfach dadurch, daß die freien Enden der Schenkelteile des Tragebügels abgerundet sind und daß die Schwenkbewegung des Tragebügels durch Anschlag der Schenkelteile in den Aussparungen der Befestigungswinkel auf 90° begrenzt ist.

Die Erfindung wird anhand eines in den Zeichnungen dargestellten Ausführungsbeispiels näher erläutert. Es zeigt:

Fig. 1 eine Teilansicht mit der Anbringung eines horizontal ausgerichteten Tragebügels an der mit einer Vertiefung versehenen Seitenwand eines Gehäuses und

Fig. 2 eine Teilansicht mit der Anbringung eines vertikal ausgerichteten Tragebügels an derselben mit einer Vertiefung versehenen Seitenwand des Gehäuses.

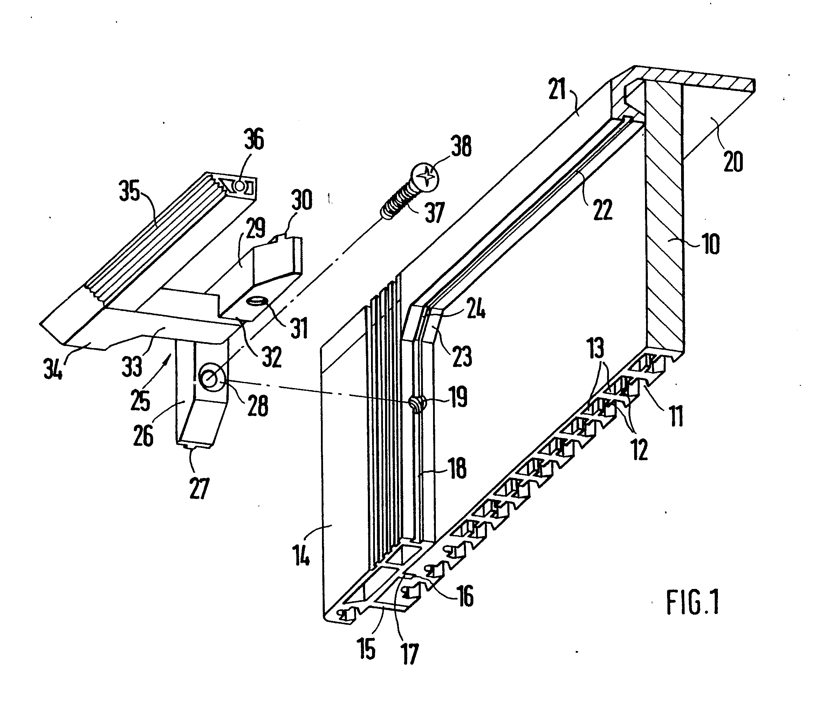

Von dem Gehäuse ist in Fig. 1 nur die Seitenwand 10 teilweise gezeigt. Diese Seitenwand 10 hat auf der Innenfläche in gleichmäßigem Raster vertikal verl-ufende Befestigungsnuten 11, die mit aufeinander ausgerichteten Querstegen 12 versehen sind und eine hinterschnittene Aufnahme 13 abteilen. Die horizontale Leiste 20 und die vertikale Leiste 14 begrenzen die Vertiefung, die damit auf der Außenfläche der Seitenwand 10 gebildet wird. Die rechte und die untere Seite der Vertiefung werden in gleicher Weise durch Leisten begrenzt. Dabei kann die Feder 17 der Leiste 14 in der Nut 16 der Seitenwand 16 geführt werden und der Schenkel 15 der Leiste 14 legt sich an die vertikale Kante der Seitenwand 10 an. Der Teil 21 der horizontalen Leiste 20 und die Leiste 14 stehen um denselben Betrag an der Außenfläche der Seitenwand 10 vor und begrenzen als Seitenwände die Vertiefung. Dabei ist an dem Teil 21 der Leiste 20 das Teil 23 angebracht, das die Ecke der Vertiefung abschrägt. Mit vier Leisten wird also so eine Vertiefung begrenzt, deren Ecken alle gleich abgeschrägt sind. Die Seitenwände der Vertiefung weisen eine umlaufende Nut auf, wie die Teilstücke 18, 22 und 24 zeigen. Außerdem ist in jedem Eckbereich eine als Gewindesacklochbohrung ausgebildete Befestigungsaufnahme 19 für das als Schraube ausgebildete Verbindungsmittel 37.

Der Tragebügel wird aus dem Griffteil 35 und zwei Schenkelteilen 33 zusammengesetzt. Dabei ist das Griffteil 35 ein Abschnitt eines Hohlprofiles mit einer durchgehenden, hülsenförmigen Befestigungsaufnahme 36. Die Schenkelteile 33 sind im Verbindungsbereich verbreitert, wie das Ende 34 zeigt. Dabei ist die Außenseite so ausgespart, daß in der Ausgangsstellung der Schenkel 26 des Befestigungswinkels 25 vollständig äufgenommen wird und ein bündiger Übergang von der Leiste 14 zu dem Schenkelteil 33 und dem Befestigungswinkel 25 erreicht wird. Der Befestigungswinkel 25 mit den beiden Schenkeln 26 und 29 hat auf der Außenfläche die Federn 27 und 30, die mit den Nuten der Vertiefung in Eingriff gebracht werden können. Die äußere Ecke des Befestigungswinkels 25 ist ähnlich dem Teil 23 der Vertiefung abgeschrägt. Die Länge des Griffteils 35 ist auf die horizontale Abmessung der Vertiefung abgestimmt, wobei an beiden Enden ein Schenkelteil 33 mit dem verbreiterten Ende 34 angebracht ist.

Der Tragebügel wird dann mit den beiden Befestigungswinkeln 25 an den Seitenwänden der Vertiefung befestigt. Dabei wird in das Befestigungsloch 28 des Schenkels 26 die Senkkopfschraube als Verbindungsmittel eingeführt und in die als Gewindesacklochbohrung ausgebildete Befestigungsaufnahme 19 eingeschraubt. Die gleichzeitig wirksame Nut-Feder-Verbindung legt den Befestigungswinkel 25 eindeutig fest. Der Senkkopf 38 der Senkkopfschraube findet in dem erweiterten Ende des Befestigungsloches 28 Platz, so daß er die Schwenkbewegung des Tragebügels nicht behindert.

Die freien Enden der Schenkelteile 33 sind in der Aussparung 32 auf der Innenseite des Schenkels 29 drehbar gelagert. Die Drehachsen verlaufen parallel zu dem Griffteil 35 und zu dem Schenkel 29 des Befestigungswinkels 25. Das freie Ende des Schenkelteils 33 ist abgerundet und mit einem Lagerbolzen, der den Schenkel 26 und das Schenkelteil 33 durchdringt und in den Schenkel 29 des Befestigungswinkels 25 reicht. Wie die Teilansicht erkennen läßt, ist die Drehlagerung so gewählt, daß die Aussparung 32 als Anschlag wirkt und die Ausschwenkbewegung des Tragebügels auf 90° begrenzt.

Die Verbindung zwischen dem Griffteil 35 und den Schenkelteilen 33 übernehmen Schrauben, die durch Bohrungen der verbreiterten Enden 34 geführt und in die Befestigungsaufnahme 36 eingeschraubt sind.

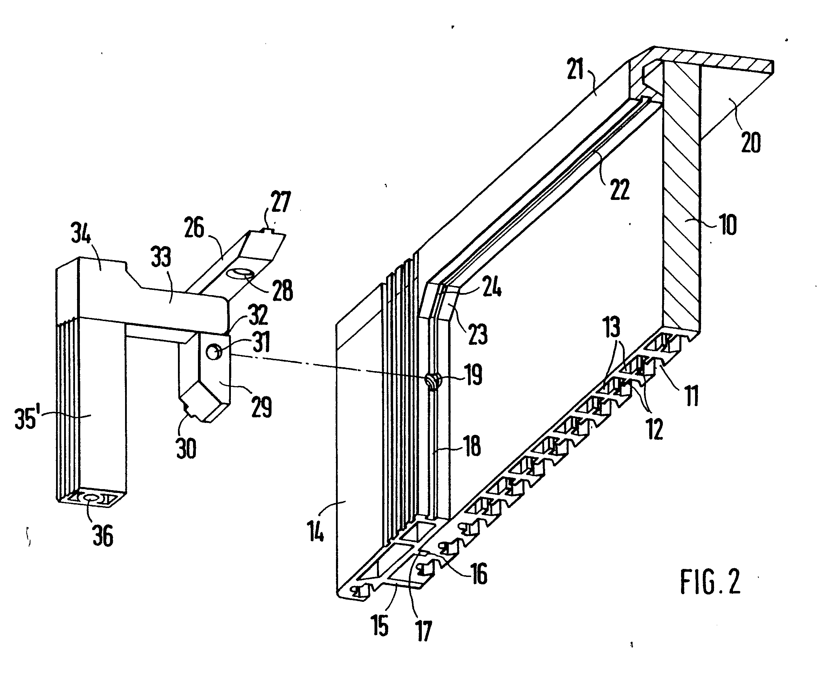

Wie die Teilansicht nach Fig. 2 zeigt, kann der Tragebügel auch mit vertikal ausgerichtetem Griffteil 35' in der Vertiefung des Gehäuses schwenkbar gelagert werden, Die Drehlagerung des Tragebügels mit den Schenkelteilen 33 in den Befestigungswinkeln 25 bleibt unverändert. Hat die Vertiefung vertikal eine andere Abmessung, dann wird zum Zusammensetzen des Tragebügels ein entsprechend bemessener Abschnitt des Hohlprofils verwendet, wie das Bezugszeichen 35' andeutet. Ist die Vertiefung quadratisch, dann wird ein einheitlich ausgebildeter Tragebügel verwendet, der in beliebiger Ausrichtung mit den Seitenwänden der Vertiefung verbunden werden kann. Dabei kann jede beliebige Seite der Vertiefung mit den zugeordneten zwei Ecken als Bezugspunkt benutzt werden. Der Tragebügel kann daher in vier verschiedenen Stellungen mit dem Gehäuse verbunden werden, das dann horizontal oder vertikal ausgerichtet getragen werden kann. Bei einer rechteckförmigen Vertiefung sind lediglich pro Tragebügel zwei unterschiedlich lange Griffteile 35 bzw. 35' erforderlich, um jederzeit die Ausrichtung der Tragebügel am Gehäuse ändern zu können.

Wie die Fig. 2 erkennen läßt, wird die Senkkopfschraube dabei in das Befestigungsloch 31 des Schenkels 29 eingeführt und in die Befestigungsaufnahme 19 eingeschraubt. Es reicht aufgrund des Nut-Feder-Eingriffes aus, in jedem Eckbereich nur eine Befestigungsaufnahme 19 vorzusehen. Es ist nur erforderlich, daß die Befestigungslöcher 28 und 31 in den Schenkeln 26 und 29 denselben Abstand von der gedachten Ecke des Befestigungswinkels 25 einnehmen. Der Tragebügel wird an der linken Seitenwand der Vertiefung befestigt, wobei die linke obere und die linke untere Ecke der Vertiefung durch die beiden Befestigungswinkel 25 belegt werden. In gleicher Ausrichtung des Tragebügels können die beiden Befestigungswinkel 25 auch an der rechten Seitenwand der Vertiefung befestigt werden. Dann werden die obere rechte und die untere rechte Ecke belegt. Die rechte Seitenwand trägt die beiden Befestigungsaufnahmen 19.

## Ansprüche

1. Tragevorrichtung für quaderförmige Gehäuse elektrischer Geräte, insbesondere für 19"-Tischgehäuse, bei der an zwei einander gegenüberliegenden vertikalen Seitenwänden des Gehäuses jeweils eine Vertiefung eingebracht ist, in der ein Tragebügel schwenkbar gelagert und aus einer mit der Seitenwand bündigen Ausgangsstellung in eine aus der Vertiefung ragenden Tragestellung ausschwenkbar ist,
dadurch gekennzeichnet,
daß der Tragebügel aus einem Griffteil (35,35') mit einer auf die horizontale und vertikale Abmessung der Vertiefung angepaßter Länge und zwei Schenkelteilen (33) U_förmig zusammengesetzt ist,
daß die freien Enden der Schenkelteile (33) des Tragebügels in zwei Befestigungswinkeln (25) drehbar gelagert sind, wobei die Drehachsen parallel zu dem Griffteil (35,35') und einem Schenkel (z.B. 29) der Befestigungswinkel (25) verlaufen und daß die Außenflächen der Befestigungswinkel (25) eines Tragebügels je nach Länge des Griffteiles (35 oder 35') im Bereich der beiden, einer vertikalen oder einer horizontalen Seitenwand, zugeordneten Ecken der Vertiefung anliegend mit den Seitenwänden der Vertiefung verbunden sind.

2. Tragevorrichtung nach Anspruch 1,
dadurch gekennzeichnet,
daß die Seitenwände der Vertiefung eine umlaufende Nut (18,22) oder eine umlaufende Feder aufweisen und daß die den Seitenwänden zugekehrten Außenflächen der Befestigungswinkel (25) mit entsprechenden, längs der Schenkel (26,29) derselben verlaufenden Federn (27,30) oder Nuten versehen sind, die mit den Nuten (18,22) oder Federn der Vertiefungen in Eingriff bringbar sind.

3. Tragevorrichtung nach Anspruch 1 oder 2,
dadurch gekennzeichnet,
daß die Enden der Schenkelteile (33) des Tragebügels in einer Aussparung (32) auf der Innenseite des einen Schenkels (z.B. 29) des Befestigungswinkels (25) drehbar (z.B. mittels eines Lagerbolzens) gelagert ist, wobei die Aussparung (32) bis an die Innenseite des anderen Schenkels (z.B. 26) des Befestigungswinkels (25) heranreicht.

4. Tragevorrichtung nach einem der Ansprüche 1 bis 3,
dadurch gekennzeichnet,
daß die Ecken der Vertiefungen und der Befestigungswinkel (25) abgeschrägt sind, und daß sich die Nuten und Federn über diese abgeschrägten Bereiche der Vertiefungen und Befestigungswinkel fortsetzen.

5. Tragevorrichtung nach einem der Ansprüche 1 bis 4,
dadurch gekennzeichnet,
daß mindestens ein Schenkel (26,29) des Befestigungswinkels (25) mit einem Befestigungsloch (28) für ein Verbindungsmittel (37) versehen ist, und

daß in den Eckbereichen der Vertiefungen auf das Befestigungsloch (28) abgestimmt jeweils mindestens eine Befestigungsaufnahme (19) für das Verbindungsmittel (37) eingebracht ist.

6. Tragevorrichtung nach Anspruch 5,
dadurch gekennzeichnet,
daß das Befestigungsloch (28) für eine mit Senkkopf (38) versehene Senkkopfschraube als Verbindungsmittel (37) ausgebildet ist, und
daß die Befestigungsaufnahme (19) als Gewindesackloch für die Senkkopfschraube ausgelegt ist.

7. Tragevorrichtung nach einem der Ansprüche 1 bis 5,
dadurch gekennzeichnet,
daß die Seitenwände der Vertiefungen mittels vertikaler und horizontaler Leisten (14,20) gebildet sind, die über die Außenseite der Gehäusewand (10) vorstehen.

8. Tragevorrichtung nach einem der Ansprüche 1 bis 7,
dadurch gekennzeichnet,
daß die Schenkelteile (33) im Verbindungsbereich mit dem Griffteil (35,35') so verbreitert sind, daß sie mit den Außenflächen der zugekehrten Schenkel (26) bündig abschließen, wobei die Schenkelteile (33) mit ihrer Außenkontur den zugekehrten Schenkel (26) des in der Ausgangsstellung befindlichen Befestigungswinkels (25) aufnehmen.

9. Tragevorrichtung nach einem der Ansprüche 1 bis 8,
dadurch gekennzeichnet,
daß das Griffteil (35,35') als Abschnitt eines Hohlprofils mit einer durchgehenden hülsenförmigen Befestigungsaufnahme (36) ausgebildet ist.

10. Tragevorrichtung nach einem der Ansprüche 1 bis 9,
dadurch gekennzeichnet,
daß die den Drehachsen abgekehrte Außenseite des Griffteils (35,35') und die anschließenden Stirnseiten der Schenkelteile (33) so abgeschrägt sind, daß das Griffteil (35,35') und die Schenkelteile (33) in der Ausgangsstellung des Tragebügels einen Hinterschnitt bilden.

11. Tragevorrichtung nach Anspruch 10,
dadurch gekennzeichnet,
daß die Außenseite des Griffteils (35,35') treppenförmig gestaltet ist.

12. Tragevorrichtung nach einem der Ansprüche 1 bis 11,
dadurch gekennzeichnet,
daß die Vertiefungen in horizontaler und in vertikaler Richtung gleiche Abmessungen aufweisen.

13. Tragevorrichtung nach einem der Ansprüche 1 bis 12,
dadurch gekennzeichnet,

daß die freien Enden der Schenkelteile (33) des Tragebügels abgerundet sind und

daß die Schwenkbewegung des Tragebügels durch Anschlag der Schenkelteile (33) in den Aussparungen (32) der Befestigungswinkel (25) auf 90° begrenzt ist.

FIG.1

0 262 453

A6213

FIG. 2

0 262 453

A 6213